# EUROPEAN PATENT APPLICATION

(11) **EP 3 410 503 A1**
(43) Date of publication of application: **05.12.2018**
(21) Application number: 17743982.5
(22) Date of filing: 13.01.2017
(51) Int. Cl.: H01L 35/32, H01L 35/22, H01L 35/24, H02N 11/00

(54) **THERMOELECTRIC CONVERSION ELEMENT AND THERMOELECTRIC CONVERSION ELEMENT MOUNTING STRUCTURE**

(30) Priority: 25.01.2016 JP 2016011903
(71) Applicant: SEKISUI POLYMATECH CO., LTD., Saitama 3380837 (JP)
(72) Inventor: WATANABE Yasuyoshi, Saitama-city Saitama 338-0837 (JP)
(74) Representative: Schmid, Wolfgang
(86) International application number: PCT/JP2017/001102
(87) International publication number: WO 2017/130751

(57) **Abstract**

In a thermoelectric conversion element that converts heat into electricity, the temperature difference between electrodes of a thermoelectric conversion layer is increased.

A thermoelectric conversion element (11) has a flexible base sheet (12) provided with a thermoelectric conversion layer (13), a first electrode (14a) and a second electrode (14b) provided at longitudinal ends of the thermoelectric conversion layer (13), and a heat insulation layer (15) provided on a back surface of the base sheet (12) at a position overlapping the first electrode (14a). Therefore, when the thermoelectric conversion element (11) is attached to a heat-generating component (18), the first electrode (14a) is raised in height by the heat insulation layer (15) so as to be disposed farther away from the heat-generating component (18) than the second electrode (14b), and moreover, thermal conduction from the heat-generating component (18) is suppressed by the heat insulation layer (15). Accordingly, the temperature difference between one end of the thermoelectric conversion layer (13) provided with the electrode (14a) and the other end of the thermoelectric conversion layer (13) provided with the electrode (14b) can be increased, thereby increasing the power conversion efficiency of the thermoelectric conversion element (11).

## Description

### Technical Field

The present invention relates to thermoelectric conversion elements that convert heat into electricity.

### Background Art

A thermoelectric conversion element is an element in which, when a temperature difference is applied to opposite ends of a thermoelectric conversion material composed of, for example, a semiconductor, an electromotive force proportional to the temperature difference is obtained. This phenomenon is called a Seebeck effect, and materials with high Seebeck coefficients are researched at many research institutions for obtaining a large electromotive force. The power conversion efficiency of such a thermoelectric conversion element is dependent on the characteristics of the material and on the temperature difference. Therefore, if the same material is to be used, the element structure that effectively increases the temperature difference between the opposite ends of the element is the key for increasing the power conversion efficiency.

Japanese Unexamined Patent Application Publication No. 9-008362 (Patent Literature 1) describes a π-type structure as such a thermoelectric conversion element. Moreover, Japanese Unexamined Patent Application Publication No. 2014-146708 (Patent Literature 2) describes a structure in which electrodes are provided at opposite ends of a flat thermoelectric conversion layer and in which a heat insulation layer and a high heat conduction layer are disposed at specific positions so that a temperature difference is caused to occur at the opposite ends of the thermoelectric conversion layer.

### Citation List

### Patent Literature

PTL 1: Japanese Unexamined Patent Application Publication No. 9-008362
PTL 2: Japanese Unexamined Patent Application Publication No. 2014-146708

### Summary of Invention

### Technical Problem

However, because the π-type thermoelectric conversion element described in Japanese Unexamined Patent Application Publication No. 9-008362 (Patent Literature 1) has a structure in which the thermoelectric conversion layer is interposed between the electrodes, the temperature difference between the electrodes decreases as the thermoelectric conversion layer is reduced in thickness, thus making it necessary to increase the thickness of the thermoelectric conversion layer for obtaining a significant temperature difference. In the aforementioned literature, it is described that an optimal thickness for the thermoelectric conversion layer is 1 mm to 2 mm or 2 mm to 3 mm.

In the structure described in Japanese Unexamined Patent Application Publication No. 2014-146708 (Patent Literature 2), in order to cause a temperature difference to occur between the opposite ends of the flat thermoelectric conversion layer, many components are required, which is problematic in terms of high costs. Moreover, since heat is transferred to the electrodes via many layers, such as an adhesive layer, a bonding layer, and a heat absorbing layer, in addition to the heat conduction layer, these many layers inhibit heat conduction, which is problematic in terms of poor heat conduction efficiency.

The present invention has been made to solve the problems mentioned above. Specifically, an object of the present invention is to apply a new configuration not existing in the related art to a thermoelectric conversion element so as to increase the temperature difference between opposite ends of a thermoelectric conversion layer. Another object of the present invention is to achieve a thermoelectric conversion element with a simple configuration.

### Solution to Problem

The present invention that achieves the aforementioned objects is configured as follows.

Specifically, the present invention provides a thermoelectric conversion element including a thermoelectric conversion layer having flexibility, a first electrode provided at one end of the thermoelectric conversion layer, a second electrode provided at the other end of the thermoelectric conversion layer, and a heat insulation layer provided at a position overlapping the first electrode in a thickness direction of the thermoelectric conversion layer. In a state where the heat insulation layer is attached to a heat-generating component, the thermoelectric conversion layer bends and deforms so that the first electrode is disposed farther away from the heat-generating component than the second electrode owing to the heat insulation layer.

Furthermore, the present invention provides an attachment structure for attaching the aforementioned thermoelectric conversion element to a heat-generating component. The first electrode is disposed farther away from the heat-generating component than the second electrode at least by a distance equivalent to a thickness of the heat insulation layer.

In the thermoelectric conversion element and the attachment structure thereof according to the present invention, in a state where the heat insulation layer is attached to the heat-generating component, the thermoelectric conversion layer bends and deforms so that the first electrode is disposed farther away from the heat-generating component than the second electrode owing to the heat insulation layer.

Therefore, in accordance with the superimposed effect of the spatial gap from the heat-generating component by a distance equivalent to the thickness of the heat insulation layer and the insulation effect caused by the interposition of the heat insulation layer, the heat of the heat-generating component is less likely to be transferred to the first electrode and to one end of the thermoelectric conversion element provided therewith.

In contrast, the heat of the heat-generating component can be readily transferred to the second electrode and to the other end of the thermoelectric conversion element provided therewith since they are attached closer to the heat-generating component than the first electrode without the interposition of the heat insulation layer.

In the present invention, the temperature difference between the first electrode and the second electrode is increased in this manner so that the power conversion efficiency can be increased.

More specifically, the thermoelectric conversion element according to the present invention can be configured as the following two aspects.

Firstly, the present invention provides a thermoelectric conversion element including a base sheet having flexibility, a thermoelectric conversion layer having flexibility and provided at the base sheet, a first electrode provided at one end of the thermoelectric conversion layer, a second electrode provided at the other end of the thermoelectric conversion layer, and a heat insulation layer provided at a position overlapping the first electrode in a thickness direction of the base sheet. In a state where the heat insulation layer is attached to a heat-generating component, the base sheet and the thermoelectric conversion layer bend and deform so that the first electrode is disposed farther away from the heat-generating component than the second electrode owing to the heat insulation layer.

Secondly, the present invention provides a thermoelectric conversion element including a release sheet, a thermoelectric conversion layer having flexibility and provided at the release sheet, a first electrode provided at one end of the thermoelectric conversion layer, a second electrode provided at the other end of the thermoelectric conversion layer, and a heat insulation layer provided at a position overlapping the first electrode in a thickness direction of the release sheet. In a state where the heat insulation layer is attached to a heat-generating component, the release sheet and the thermoelectric conversion layer bend and deform so that the first electrode is disposed farther away from the heat-generating component than the second electrode owing to the heat insulation layer. In the present invention, the release sheet may be releasable in the bent and deformed state.

The first and second thermoelectric conversion elements described above can each achieve the effect of increasing the temperature difference between the opposite ends of the thermoelectric conversion layer, as described above, by a simple configuration including the base sheet or the release sheet, the thermoelectric conversion layer, the electrodes, and the heat insulation layer.

Since the base sheet or the release sheet can have a flat shape, the thermoelectric conversion layer, a wire, and so on can be formed more readily by printing. Furthermore, in that case, the thermoelectric conversion layer can be readily formed to have a uniform thickness, and the wire can be readily miniaturized.

The thermoelectric conversion layer can be reduced in thickness since it utilizes a temperature difference in the planar direction instead of the thickness direction of the sheet. In addition, by forming the heat insulation layer after forming each layer having a thin-film shape, the heat insulation layer can also be formed on the substantially flat sheet. Therefore, the heat insulation layer can also be printed and formed to have a uniform thickness.

Furthermore, when in actual use, the first and second thermoelectric conversion elements each exhibit performance equivalent to that of a thermoelectric conversion element having a three-dimensional structure regardless of the fact that the layers, such as the thermoelectric conversion layer, can be readily formed as uniformly-thin films on a flat sheet. Specifically, the thermoelectric conversion elements can each increase the temperature difference between the electrodes of the thermoelectric conversion layer while having a thin and simple configuration.

In the present invention described above, the heat insulation layer may have a thickness of 0.1 to 2.0 mm. With the heat insulation layer having a thickness of 0.1 to 2.0 mm, the thermoelectric conversion element can be prevented from becoming too thick while the temperature difference of the thermoelectric conversion layer can be increased.

In the present invention described above, a length from an end of the first electrode to an end of the second electrode may be 1 to 50 mm.

With the length being 1 to 50 mm, a length corresponding to the thickness of the heat insulation layer can be ensured.

In the present invention described above, a protection layer that covers the thermoelectric conversion layer may be further provided. Providing the protection layer enhances the durability of the thermoelectric conversion element.

The protection layer may have a thin section located at a position overlapping the heat insulation layer and a thick section located at a position not overlapping the heat insulation layer. Accordingly, in a state where the thermoelectric conversion element is attached to the heat-generating component, the upper surface of the thermoelectric conversion element located above the heat insulation layer can be prevented from protruding, or protruding of the upper surface can be reduced.

In the present invention described above, an adhesive layer to be attached to the heat-generating component may be further provided. Providing the adhesive layer facilitates the attachment to a high-temperature component.

### Advantageous Effects of Invention

The present invention can provide a thin thermoelectric conversion element that can increase the temperature difference between electrodes of a thermoelectric conversion layer while having a simple configuration.

### Brief Description of Drawings

[Fig. 1] Fig. 1 is a plan view of a thermoelectric conversion element according to a first embodiment.
[Fig. 2] Fig. 2 is a cross-sectional view taken along line SA-SA in Fig. 1.
[Fig. 3] Fig. 3 is a cross-sectional view illustrating an attachment structure of the thermoelectric conversion element in Fig. 2.
[Fig. 4] Fig. 4 is a cross-sectional view of a thermoelectric conversion element according to a first modification and corresponds to Fig. 2.
[Fig. 5] Fig. 5 is a cross-sectional view illustrating an attachment structure of the thermoelectric conversion element in Fig. 4.
[Fig. 6] Fig. 6 is a cross-sectional view of a thermoelectric conversion element according to a second embodiment and corresponds to Fig. 2.
[Fig. 7] Fig. 7 is a cross-sectional view illustrating an attachment structure of the thermoelectric conversion element in Fig. 6.
[Fig. 8] Fig. 8 is a cross-sectional view of a thermoelectric conversion element according to a third embodiment and corresponds to Fig. 2.
[Fig. 9] Fig. 9 is a cross-sectional view illustrating an attachment structure of the thermoelectric conversion element in Fig. 8.
[Fig. 10] Fig. 10 is a cross-sectional view of a thermoelectric conversion element according to a second modification and corresponds to Fig. 2.
[Fig. 11] Fig. 11 is a cross-sectional view illustrating an attachment structure of the thermoelectric conversion element in Fig. 10.
[Fig. 12] Fig. 12 is a cross-sectional view of a thermoelectric conversion element in the related art and corresponds to Fig. 2.

### Description of Embodiments

Embodiments will be described in further detail. In each of the embodiments, redundant descriptions with regard to the same material, composition, preparation method, operation, and effect will be omitted.

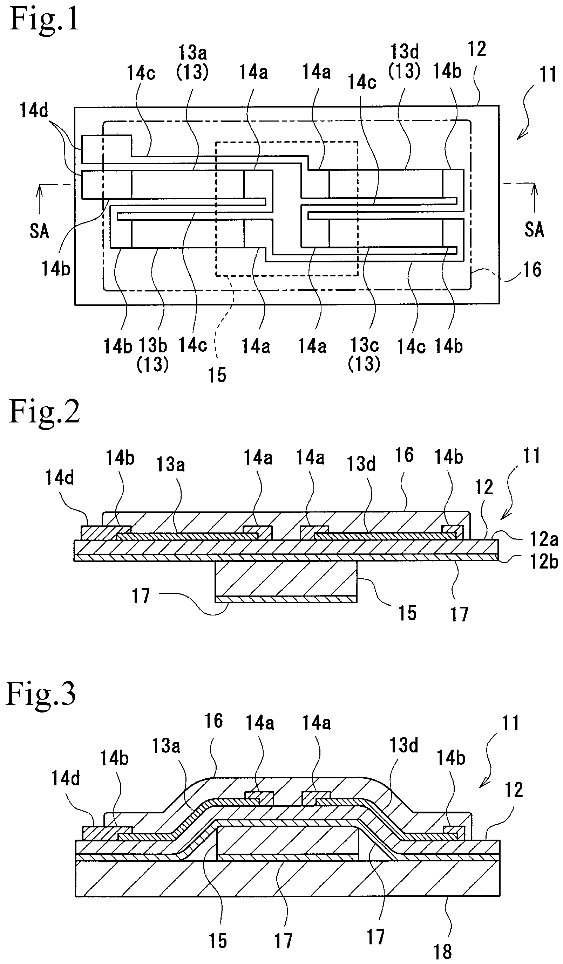

### First Embodiment [Fig. 1 to Fig. 3]:

A thermoelectric conversion element 11 and an attachment structure thereof according to this embodiment will now be described. Fig. 1 is a plan view of the thermoelectric conversion element 11, and Fig. 2 is a cross-sectional view thereof. The thermoelectric conversion element 11 includes a base sheet 12, thermoelectric conversion layers 13a to 13d, first electrodes 14a and second electrodes 14b, and a heat insulation layer 15.

For the sake of convenience, of the front and back surfaces of the base sheet 12, a first surface opposite from the heat insulation layer 15 to be described later will be referred to as a front surface 12a, and a second surface in contact with the heat insulation layer 15 will be referred to as a back surface 12b. The front surface 12a of the base sheet 12 is provided with the four thermoelectric conversion layers 13a to 13d having a substantially rectangular shape. Opposite longitudinal ends of each of the thermoelectric conversion layers 13a to 13d are respectively provided with a first electrode 14a and a second electrode 14b. The four thermoelectric conversion layers 13a to 13d will be described as thermoelectric conversion layers 13
when they are not to be distinguished from one another. Moreover, the first electrodes 14a and the second electrodes 14b will be described as electrodes 14 when they are not to be distinguished from each other.

One end of the thermoelectric conversion layer 13a is provided with a second electrode 14b, and this second electrode 14b serves as an external contact 14d. The other end of the thermoelectric conversion layer 13a is provided with a first electrode 14a. This first electrode 14a is conductively connected to the second electrode 14b of the thermoelectric conversion layer 13b via a wire 14c. The first electrode 14a opposite from the second electrode 14b of the thermoelectric conversion layer 13b is conductively connected to the second electrode 14b of the thermoelectric conversion layer 13c via a wire 14c. The first electrode 14a of the thermoelectric conversion layer 13c is connected to the second electrode 14b of the thermoelectric conversion layer 13d via a wire 14c. The first electrode 14a opposite from that second electrode 14b is extended to the left end (Fig. 1) of the base sheet 12 via a wire 14c so as to serve as an external contact 14d. In plan view of this structure shown in Fig. 1, the first electrodes 14a are disposed toward the center of the base sheet 12, and the second electrodes 14b are disposed toward the ends of the base sheet 12.

The front surface 12a of the base sheet 12 is provided with a protection layer 16 that covers, for example, all of the thermoelectric conversion layers 13 and the electrodes 14 while exposing the external contacts 14d. For the sake of convenience, the protection layer 16 is indicated by an imaginary two-dot chain line in Fig. 1.

The back surface 12b of the base sheet 12 is provided with the heat insulation layer 15 at a position overlapping the first electrodes 14a of all of the thermoelectric conversion layers 13 in plan view.

The back surface 12b of the base sheet 12 and the back surface of the heat insulation layer 15 are provided with adhesive layers 17.

The above-described components constituting the thermoelectric conversion element 11 will now be described.

The base sheet 12 is an insulating resin film having flexibility. Examples of the material that may be used include polyethylene terephthalate (PET) resin, polyethylene naphthalate (PEN) resin, polycarbonate (PC) resin, polyimide (PI) resin, methacrylate (PMMA) resin, polypropylene (PP) resin, polyurethane (PU) resin, polyamide (PA) resin, polyether sulfone (PES) resin, polyether ether ketone (PEEK) resin, triacetyl cellulose (TAC) resin, and a cyclo olefin polymer (COP).

The base sheet 12 may include a primer layer that enhances adhesiveness with the thermoelectric conversion layers 13 and the electrodes 14 or may be surface-treated to enhance adhesiveness with a heat-generating component 18, which will be described later.

The base sheet 12 preferably has a thickness of 10 to 200 µm. With a thickness of up to 200 µm, the thermoelectric conversion element 11 can have sufficient strength, while there is no need to increase the thickness beyond 200 µm to enhance the strength. There is also a disadvantage in increasing the thickness beyond 200 µm in that heat transferability from the heat-generating component 18 is reduced. On the other hand, if the thickness is smaller than 10 µm, there is a concern that the durability of the base may be insufficient.

The thermoelectric conversion layers 13 may be composed of, for example, an inorganic thermoelectric conversion material, such as a semiconductor or oxide thermoelectric conversion material, which is a p-type thermoelectric conversion material or an n-type thermoelectric conversion material, or a magnetic material that can utilize a spin Seebeck effect, or may be composed of, for example, an organic thermoelectric conversion material mainly constituted of a conductive polymer. More specifically, examples of the inorganic thermoelectric conversion material include a semiconductor, such as Bi₂Te₃, a CoO₂-based layered cobalt oxide, a filled skutterudite or clathrate compound, and a whistler compound, and an example of the organic thermoelectric conversion material includes a conductive polymer, such as polyaniline or polyethylenedioxythiophene having carbon nanotube or other carbon nanomaterials dispersed therein.

The π-type thermoelectric conversion element described as an example in the related art has a structure in which a thermoelectric conversion layer is sandwiched between electrodes and is therefore not designed to deform the thermoelectric conversion layer in the thickness direction. Moreover, since a temperature difference occurring in the thickness direction between the electrodes is utilized, the thermoelectric conversion layer is increased in thickness to increase the temperature difference, thus making it difficult to cause the thermoelectric conversion layer to deform. In contrast, in the thermoelectric conversion element 11 according to the embodiment of the present invention, the thermoelectric conversion layers 13 bend and deform so that the first electrodes 14a are disposed farther away from the heat-generating component 18 than the second electrodes 14b owing to the heat insulation layer 15, whereby the temperature difference between the opposite ends of the thermoelectric conversion layers 13 is increased. Therefore, the organic thermoelectric conversion material or the inorganic thermoelectric conversion material used for forming the thermoelectric conversion layers 13 has flexibility for allowing the thermoelectric conversion layers 13 to bend and deform in this manner. Furthermore, in view of the flexibility and material characteristics of such a thermoelectric conversion material as well as the size of the thermoelectric conversion element 11, it is conceivable that the thermoelectric conversion layers 13 composed of an organic thermoelectric conversion material preferably have a thickness of 10 to 500 µm, and that the thermoelectric conversion layers 13 composed of an inorganic thermoelectric conversion material preferably have a thickness of 0.1 to 10 µm.

It is preferable that the distance between the electrodes of each thermoelectric conversion layer 13 (i.e., the length of the thermoelectric conversion layer 13 provided with the first electrode 14a and the second electrode 14b at the opposite sides thereof) range between 1 mm and 50 mm. When the distance between the electrodes is smaller than 1 mm, it is difficult to cause a sufficient temperature difference to occur between the opposite ends of the thermoelectric conversion layer 13. On the other hand, if the distance between the electrodes exceeds 50 mm, it is similarly difficult to cause a sufficient temperature difference to occur between the opposite ends of the thermoelectric conversion layer 13, and a resistance value between the electrodes also increases with the increase in the distance between the electrodes, possibly causing the thermoelectric conversion efficiency to deteriorate. It is preferable to set the distance between the electrodes to 1 to 50 mm since heat transferability can be sufficiently suppressed.

The electrodes 14 may each be composed of a conductive material used in electric wiring. Examples include metal, such as copper, nickel, silver, or aluminum, and a conductive material having conductive particles, such as silver particles, dispersed in a binder. Of these materials, a conductive paste (i.e., conductive coating liquid) having conductive particles dispersed in a binder is particularly preferred. With a conductive paste, a circuit pattern can be formed by printing, which is advantageous in that a circuit with a high degree of freedom in wiring can be formed with a smaller number of steps than a circuit pattern formed by etching copper foil as in the related art.

The conductive paste used may be prepared by (1) dissolving conductive particles and a binder in a solution, (2) dissolving conductive particles and a precursor (main agent and a curing agent) of a binder in a solution, or (3) dispersing conductive particles in a precursor of a binder in a case where the precursor of the binder is a liquid. In addition to the aforementioned components, for example, a dispersing agent, an antifoaming agent, an ultraviolet absorbing agent, and an anti-oxidizing agent may be appropriately added to the conductive paste.

The conductive particles may be metallic particles. Specifically, examples include silver, copper, aluminum, nickel, or an alloy of these metals, or may be metallic particles coated with silver or gold. Of these materials, silver particles that are highly conductive and weather resistant are preferably used.

The binder used may be an organic polymer. Specifically, various types of resin, such as acrylic, epoxy, polyester, polyurethane, phenol resin, melamine resin, silicone, polyamide, polyimide, and polyvinyl chloride, may be used. Of these materials, polyester is preferred.

The electrodes 14 may have a thickness of 2 to 50 µm. It is more preferable that the thickness be 4 to 20 µm. When the thickness is smaller than 2 µm, the resistance value may possibly increase. When the thickness exceeds 50 µm, the amount of conductive paste used increases, resulting in an increase in cost. By setting the thickness to 4 µm or larger, the electrodes 14 can have low resistance. Moreover, by setting the thickness to 20 µm or smaller, the step between the electrodes 14 and the surrounding surface of the base sheet 12 becomes smaller, and inclusion of air bubbles can be suppressed when applying the protection layer 16.

If the aforementioned conductive paste is to be used, the electrodes 14 can be applied on the base sheet 12 by printing the conductive paste thereon. The wires 14c and the external contacts 14d other than the electrodes 14 can be simultaneously formed by using the same material as the electrodes 14.

The heat insulation layer 15 is preferably composed of a material having a thermal conductivity of 0.1 W/m-K or lower. Specifically, for example, a polymeric foam or a polymeric porous medium obtained by filling a high polymer with a hollow filler, or an inorganic porous medium composed of an inorganic material, such as aerogel, may be used. Of these materials, a polymeric foam is preferably used in terms of flexibility and ease of manufacture.

The material of the foam is resin or rubber, and examples include polystyrene, polyurethane, polyethylene, silicone, an acrylonitrile copolymer, polyolefin rubber, acrylic rubber, and fluorocarbon rubber.

Although the foam may be of either an open-cell type or a closed-cell type, the open-cell type may possibly cause heat transfer due to convection of gas through continuous pores, whereas the closed-cell type does not cause convention of gas so that the insulation effect can be enhanced. Therefore, it is preferable that the closed-cell type be used.

The heat insulation layer 15 formed of a polymeric foam can be fabricated in accordance with a mechanical foaming technique, a physical foaming technique, or a chemical foaming technique.

Examples of a polymer composition to be filled with a hollow filler include urethane, silicone, acrylic rubber, and polyolefin rubber. Examples of the hollow filler include an inorganic hollow filler selected from a glass balloon, a silica balloon, a carbon balloon, an alumina balloon, and a zirconia balloon, and an organic hollow filler selected from a polymer of monomers selected from phenolic resin, urea resin, acrylonitrile, vinylidene chloride, acrylic ester, and methacrylic acid ester and a copolymer of two of more kinds of these monomers. It is preferable to use the organic hollow filler selected from a polymer of monomers selected from phenolic resin, urea resin, vinylidene chloride, acrylonitrile, acrylic ester, and methacrylic acid ester and a copolymer of two of more kinds of these monomers.

With regard to the specific gravity of these hollow fillers, an inorganic hollow filler has a specific gravity of about 0.1 to 0.8, and an organic hollow filler has a specific gravity of about 0.01 to 0.2. A hollow filler preferably has an average particle diameter of about 2 µm to 100 µm.

The amount of hollow filler to be blended in the polymer composition to be filled with the hollow filler is preferably 20 to 30 parts by weight, in the case of the inorganic hollow filler, and 5 to 20 parts by weight, in the case of the organic hollow filler, relative to 100 parts by weight of the polymer composition.

The heat insulation layer 15 is located at the back surface 12b of the base sheet 12 and overlaps the four first electrodes 14a in plan view so as to suppress heat transfer toward the first electrodes 14a and toward the ends of the thermoelectric conversion layers 13 near the first electrodes 14a. Consequently, these ends of the thermoelectric conversion layers 13 can be set to a relatively low temperature relative to the ends of the thermoelectric conversion layers 13 near the opposite second electrodes 14b.

The heat insulation layer 15 preferably has a thickness of 0.1 mm to 2 mm, and more preferably has a thickness of 0.5 mm to 1.5 mm. If the thickness is smaller than 0.1 mm, there is a concern that the temperature difference between the first electrodes 14a and the second electrodes 14b would not increase. If the thickness exceeds 2 mm, the temperature difference hardly changes. Furthermore, when the thickness is larger than 2 mm, distortion occurring when the base sheet 12 is bent becomes too large, possibly causing the base sheet 12 to break. In order to reduce the distortion of the base sheet 12, it is preferable that the thickness be 1.5 mm or smaller.

The protection layer 16 is an insulating resin film provided for protecting the thermoelectric conversion layers 13 and the electrodes 14 from abrasion and oxidation. In a case where the electrodes 14 contain silver, the protection layer 16 is suitable as means for preventing sulfurization thereof.

The resin material used as the protection layer 16 is preferably rigid resin, and examples include acrylic-based, urethane-based, epoxy-based, and polyolefin-based resin, as well as other types of resin. The term "rigid" used here does not mean "rigid" to an extent that the resin does not bend and deform, but is used in a sense that the resin has enough flexibility to deform in conformity to the deformation of the base sheet 12, as shown in Fig. 3.

The thickness of the protection layer 16 may be 6 to 30 µm and is preferably 10 to 20 µm. The thickness exceeding 30 µm would lead to poor flexibility, and the thickness being smaller than 6 µm may possibly be insufficient for protecting of the thermoelectric conversion layers 13 and the electrodes 14.

As shown in Fig. 2, the thermoelectric conversion element 11 has components, such as the thermoelectric conversion layers 13 and the heat insulation layer 15, on the opposite surfaces of the flat base sheet 12. As shown in Fig. 3, when the thermoelectric conversion element 11 is to be attached to the heat-generating component 18, the surface of the heat insulation layer 15 and the exposed surface of the back surface 12b of the base sheet 12 are attached and adhered to the heat-generating component 18 via the adhesive layers 17. Therefore, in the attached state, these surfaces are flush with the surface of the heat-generating component 18. In other words, the first electrodes 14a of the base sheet 12 and the surrounding sections thereof are disposed away from the heat-generating component 18 by a distance equivalent to the thickness of the heat insulation layer 15.

According to the thermoelectric conversion element 11 and the attachment structure thereof, since the base sheet 12 is flat, the circuit components constituting the element, such as the thermoelectric conversion layers 13 and the wires 14c, can be readily formed by printing. The thermoelectric conversion layers 13 can be readily formed to have a uniform thickness, and the wires 14c can be formed finely. Furthermore, by forming the heat insulation layer 15 by printing after forming the thermoelectric conversion layers 13 and the wires 14c, the heat insulation layer 15 can also be provided on the substantially flat base sheet 11, and the heat insulation layer 15 can also be formed to have a uniform thickness.

According to the attachment structure of the thermoelectric conversion element 11, during the manufacturing process thereof, the circuit components constituting the element can be readily formed as a uniformly-thin film on the flat base sheet 12. When in use, the thermoelectric conversion element 11 can exhibit performance equivalent to that of a thermoelectric conversion element having a three-dimensional structure.

At the second electrode 14b side of the thermoelectric conversion element 11, the base sheet 12 is intervened by the adhesive layer 17 but is substantially directly in contact with the heat-generating component 18. Therefore, heat can be transferred from the heat-generating component 18 to the thermoelectric conversion layers 13 at the second electrode 14b side without intervention of many excessive layers. On the other hand, at the first electrode 14a side of the thermoelectric conversion element 11, the base sheet 12 is disposed away from the heat-generating component 18 by a distance equivalent to the thickness of the heat insulation layer 15. Therefore, with the insulation effect of the heat insulation layer 15 and the spatial gap created by the distance, heat is less likely to be transferred to the thermoelectric conversion layers 13 at the first electrode 14a side.

The thermoelectric conversion element 11 can have a thin and simple configuration and can utilize the temperature difference in the planar direction instead of the thickness direction so that the temperature difference between the opposite ends at the electrode 14a side and the electrode 14b side of the thermoelectric conversion layers 13 can be increased, thereby increasing the power conversion efficiency.

Furthermore, even when there are recesses and protrusions or steps on the surface of the heat-generating component 18, since the heat-generating component 18 and the thermoelectric conversion layers 13 are attached to each other with the base sheet 12 interposed therebetween, the recesses and protrusions or the steps are covered by the base sheet 12, so that the thermoelectric conversion layers 13 are less likely to break when the thermoelectric conversion element 11 is pressure-bonded to the heat-generating component 18. Consequently, the thermoelectric conversion element 11 is preferred when it is to be attached to the heat-generating component 18 provided with recesses and protrusions or steps on the surface thereof.

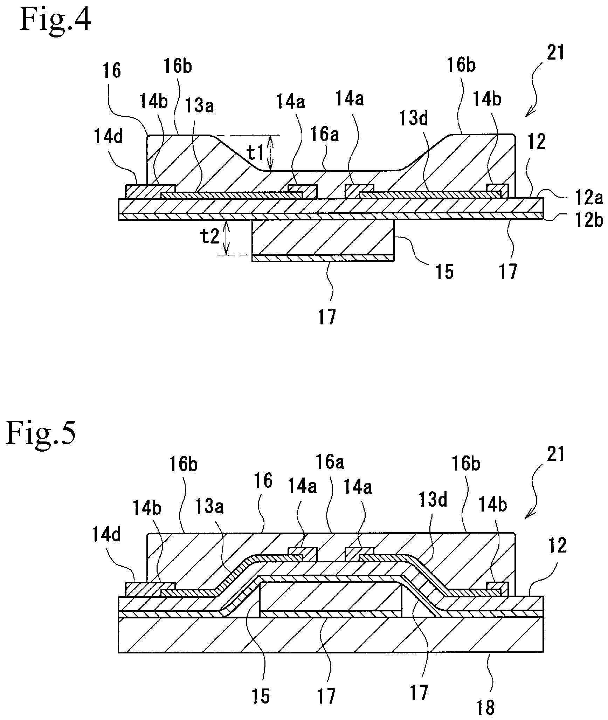

### First Modification [Figs. 4 and 5]:

Fig. 4 illustrates a thermoelectric conversion element 21 as a modification of the thermoelectric conversion element 11. Fig. 5 illustrates an attachment structure of the thermoelectric conversion element 21.

The thermoelectric conversion element 21 differs from the thermoelectric conversion element 11 in terms of the shape of the protection layer 16. Specifically, before the thermoelectric conversion element 11 is attached to the heat-generating component 18, the upper surface of the protection layer 16 is a flat surface. In contrast, before the thermoelectric conversion element 21 is attached to the heat-generating component 18, a thin section 16a is formed at and around positions overlapping the first electrodes 14a, and a thick section 16b thicker than the thin section 16a is formed at and around positions overlapping the second electrodes 14b. An increase t in thickness of the thick section 16b relative to the thin section 16a preferably corresponds to a thickness t2 of the heat insulation layer 15.

Because the thermoelectric conversion element 21 has the thick section 16b at and around the positions where the protection layer 16 overlaps the second electrodes 14b, when the base sheet 12 in this section is brought into contact with the heat-generating component 18, the thick section 16b deforms toward the heat-generating component 18, as shown in Fig. 5, so that the bulge of the thick section 16b relative to the thin section 16a is reduced or eliminated at the front surface 12a side, whereby the surface of the protection layer 16 becomes substantially flat.

According to the thermoelectric conversion element 21, the protection layer 16 of the thermoelectric conversion element 21 can be given a substantially flat surface. Therefore, another component lower in temperature than the heat-generating component 18 to be brought into contact with the protection layer 16 can be adhered thereto, so that the central section at the first electrode 14a side of the thermoelectric conversion element 21 can be decreased in temperature.

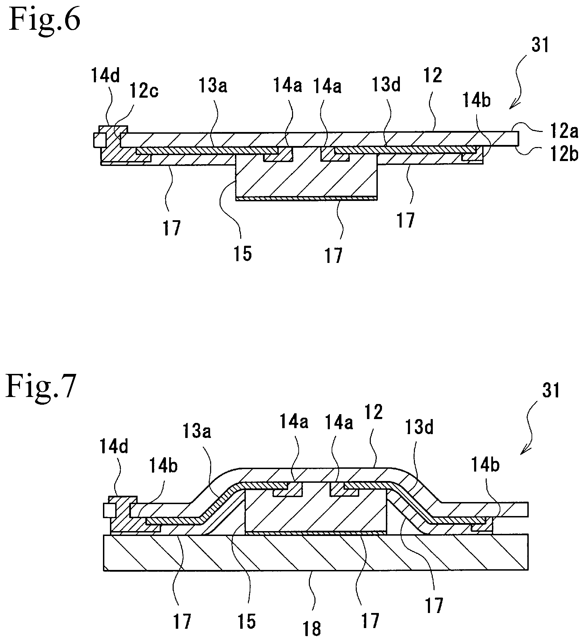

### Second Embodiment [Figs. 6 and 7]:

Fig. 6 illustrates a thermoelectric conversion element 31 to be described in this embodiment. Fig. 7 illustrates an attachment structure of the thermoelectric conversion element 31.

The thermoelectric conversion element 31 is provided with the thermoelectric conversion layers 13, the electrodes 14, and the heat insulation layer 15 on the back surface 12b of the base sheet 12. The protection layer 16 included in the thermoelectric conversion element 11 described in the previous embodiment is not provided. The external contacts 14d are formed on the front surface 12a of the base sheet 12 via through-holes 12c provided in the base sheet 12. The thermoelectric conversion layers 13 and the electrodes 14 are provided with the adhesive layers 17 that cover the surfaces thereof.

As shown in Fig. 7, when the thermoelectric conversion element 31 is to be attached to the heat-generating component 18, the adhesive layers 17 formed on the surface of the heat insulation layer 15 and on the exposed surface of the back surface 12b of the base sheet 12 are adhered to the heat-generating component 18. Therefore, in the attached state, these surfaces are flush with the surface of the heat-generating component 18. In other words, the first electrodes 14a of the base sheet 12 and the surrounding sections thereof are disposed away from the heat-generating component 18 by a distance equivalent to the thickness of the heat insulation layer 15.

Furthermore, in the thermoelectric conversion element 31, the heat from the heat-generating component 18 is transferred to the thermoelectric conversion layers 13 and the first electrodes 13a without intervention of the base sheet 12. Therefore, as compared with the first embodiment, the heat from the heat-generating component 18 is more readily transferred to the thermoelectric conversion layers 13 since the heat does not pass through the base sheet 12.

Moreover, since the heat-generating component 18 and the thermoelectric conversion layers 13 do not have the base sheet 12 interposed therebetween, the thermoelectric conversion element 31 can be preferably used in a case where the heat-generating component 18 has a smooth surface. This is because, if there are recesses and protrusions or steps on the surface of the heat-generating component 18, the recesses and protrusions or the steps may possibly damage the thermoelectric conversion layers 13 and the electrodes 14.

Because the thermoelectric conversion element 31 is not provided with the protection layer 16, the cost can be reduced by an amount equivalent to the number of steps performed for providing the protection layer 16. Moreover, without the protection layer 16 provided, the thermoelectric conversion element 31 can be reduced in thickness by an amount equivalent to the thickness of the protection layer 16.

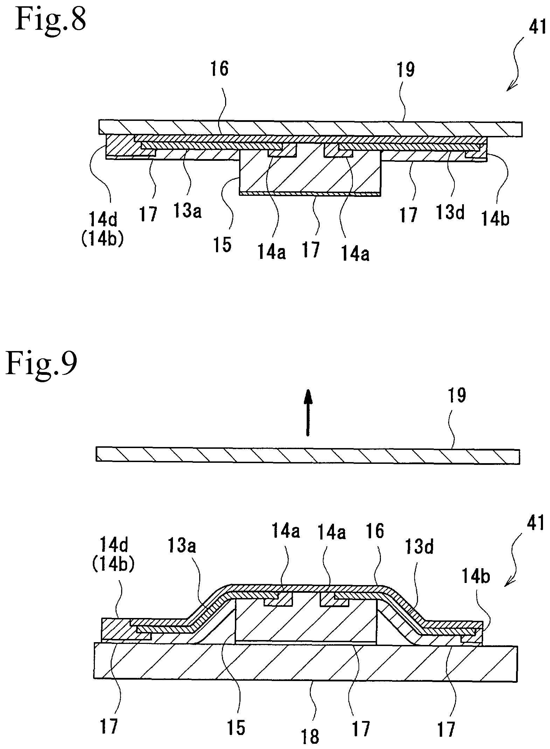

### Third Embodiment [Figs. 8 and 9]:

Fig. 8 illustrates a thermoelectric conversion element 41 according to a third embodiment. Fig. 9 illustrates an attachment structure of the thermoelectric conversion element 41.

The thermoelectric conversion element 41 is characterized in not being provided with the base sheet 12. A release sheet 19 is prepared in place of the base sheet 12, and the protection layer 16, the thermoelectric conversion layers 13, the electrodes 14, the heat insulation layer 15, and the adhesive layers 17 are sequentially stacked on the release sheet 19. The protection layer 16 has a polygonal planar shape identical to that of the protection layer 16 according to the first embodiment indicated by the imaginary line in Fig. 1, and the adhesive layers 17 are stacked directly on sections where the thermoelectric conversion layers 13, the electrodes 14, and the heat insulation layer 15 are not formed.

As shown in Fig. 9, when the thermoelectric conversion element 41 is to be attached to the heat-generating component 18, the release sheet 19 is peeled off after the adhesive layers 17 to be stacked on the surfaces of the thermoelectric conversion layers 13, the electrodes 14, the heat insulation layer 15, and the protection layer 16 are attached and adhered to the heat-generating component 18. In other words, the thermoelectric conversion element 41 provided on the release sheet 19 is transferred onto the surface of the heat-generating component 18.

The release sheet 19 may be release paper or a release film formed of a resin film that can be peeled off from the protection layer 16 and the electrodes 14. A polyethylene terephthalate film given a release treatment, which is inexpensive and readily available, is one preferred example.

As compared with the base sheet 12 used in the thermoelectric conversion element 11 described in the previous embodiment, the protection layer 16 formed in the thermoelectric conversion element 41 can be formed as a thin film. Therefore, the thermoelectric conversion element 41 can be reduced in thickness. Moreover, since the protection layer 16 is a thin film, the thermoelectric conversion element 41 can be readily cooled when brought into contact with a low-temperature component. Thus, the temperature difference between the second electrode 14b side to be brought into contact with the heat-generating component 18 and the first electrode 14a side to be brought into contact with a low-temperature component can be increased.

In this embodiment, the external contacts 14d can be exposed at the front surface 12a side without having to provide the through-holes 12c as in the thermoelectric conversion element 31 described in the previous embodiment.

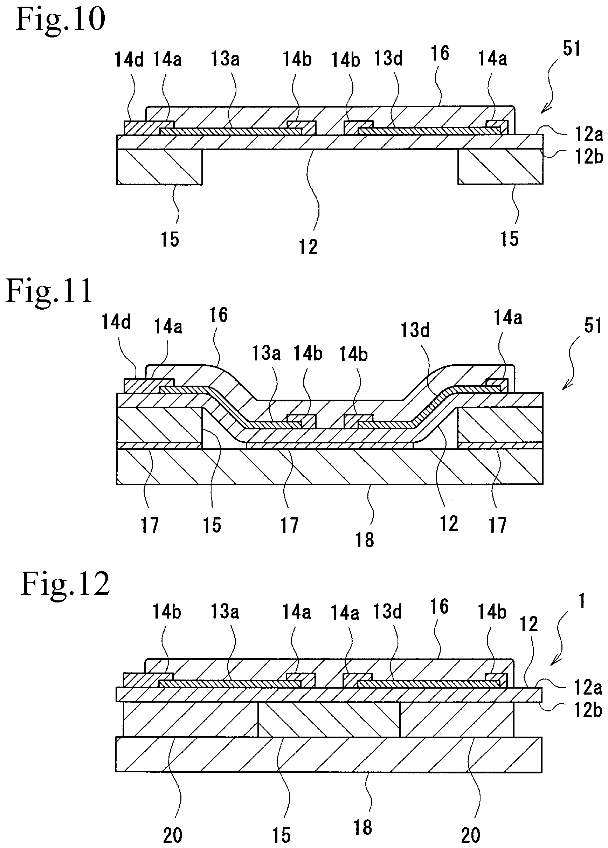

### Second Modification [Figs. 10 and 11]:

Fig. 10 illustrates a thermoelectric conversion element 51 to be described in this embodiment. Fig. 11 illustrates an attachment structure of the thermoelectric conversion element 51.

The thermoelectric conversion element 51 is characterized in that heat insulation layers 15 are provided at opposite outer sides of the base sheet 12. In the case of this configuration, the first electrodes 14a are provided at positions overlapping the heat insulation layers 15, and the second electrodes 14b are provided toward the center of the base sheet 12. Specifically, as compared with the first embodiment, the first electrodes 14a and the second electrodes 14b are positionally interchanged with each other. In this embodiment, the first electrodes 14a located at the outer peripheral side of the base sheet 12 are increased in temperature, whereas the second electrodes 14b located toward the center of the base sheet 12 are decreased in temperature, so that a predetermined temperature difference occurs between the electrodes 14a and 14b. The configuration of the thermoelectric conversion element 51 can be suitably applied when the heat-generating component 18 is small or when the high-temperature region is small due to the heat-generating component 18 having a temperature gradient.

The above-described embodiments are examples of the present invention. The embodiments may be modified or combined or a known technology may be added thereto within the scope of the present invention. Such technologies are also included in the scope of the present invention.

For example, as an embodiment achieved by combining the first modification with the second modification, in a case where heat insulation layers 15 are to be provided at the opposite outer sides as in the second modification, the protection layer 15 described in the first modification may be deformed to be increased in thickness at the opposite outer sides, and the protection layer 15 at the center corresponding to the first electrodes 14a may be increased in thickness.

### EXAMPLES

The present invention will be further described based on specific experimental examples.

### <Fabrication of Sample>

Various tests are performed by fabricating thermoelectric conversion elements of samples 1 to 7 to be described below.

### Sample 1:

As sample 1, a thermoelectric conversion element having the structure shown in Figs. 1 and 2 is fabricated. As a base sheet, polyethylene terephthalate resin with vertical sides of 50 mm, horizontal sides of 100 mm, and a thickness of 100 µm is prepared, and four thermoelectric conversion layers composed of Bi₂Te₃ and having an electrode-to-electrode distance of 30 mm, a width of 5 mm, and a thickness of 1 µm are formed on one of the surfaces of the polyethylene terephthalate resin. Then, the four thermoelectric conversion layers are connected to one another, as shown in Fig. 1, by using a silver paste, and a protection layer having a thickness of 15 µm and covering the thermoelectric conversion layers and wires is formed by using resist ink. Subsequently, a heat insulation layer having a thickness of 0.1 mm is formed on the other surface of the base sheet, whereby sample 1 is obtained. The heat insulation layer is a closed-cell foam layer composed of acrylic resin and having a density of 0.25 g/cm³ and a thermal conductivity of 0.055 W/m-K.

### Samples 2 to 5:

Thermoelectric conversion elements of samples 2 to 5 are fabricated similarly to sample 1 except that the thickness of the heat insulation layer is changed to the thicknesses shown in Table 1.

### Sample 6:

A thermoelectric conversion element of sample 6 is fabricated similarly to sample 1 except that the heat insulation layer is not provided.

### Sample 7:

As shown in Fig. 12, a thermoelectric conversion element of sample 7 as a comparative example is fabricated similarly to sample 1 except that heat conduction layers (20) having the same thickness of 0.5 mm as the heat insulation layer (15) are formed next to the heat insulation layer. The heat conduction layers are formed of thermally conductive sheets having a thermal conductivity of 1.3 W/m-K and obtained by blending aluminum oxide in silicone rubber.

**[Table 1]**

| | Sample 1 | Sample 2 | Sample 3 | Sample 4 | Sample 5 | Sample 6 | Sample 7 |
|---|---|---|---|---|---|---|---|
| Thickness (mm) of heat insulation layer | 0.1 | 0.5 | 1 | 1.5 | 2 | - | 0.5 |
| Temperature (°C) of high-temperature-side end of thermoelectric conversion layer | 41.9 | 40.9 | 41.5 | 40.9 | 41 | 40.2 | 41.4 |
| Temperature (°C) of low-temperature-side end of thermoelectric conversion layer | 39.9 | 38 | 38.3 | 37.3 | 37.3 | 40.1 | 40.5 |
| Temperature difference (°C) | 2 | 2.9 | 3.2 | 3.6 | 3.7 | 0.1 | 0.9 |

### <Temperature Tests>

After attaching each of the thermoelectric conversion elements of samples 1 to 7 described above to a heat-generating component, the temperature at a predetermined location of the thermoelectric conversion element is measured, and the temperature characteristics thereof are evaluated.

### Attaching of Thermoelectric Conversion Element to Heat-Generating Component

Each of the thermoelectric conversion elements is adhered to and disposed on the surface of a 100 W rubber heater with vertical sides of 100 mm and horizontal sides of 200 mm in plan view. The rubber heater is larger than the thermoelectric conversion element and can heat the entire thermoelectric conversion element substantially uniformly. An alternating voltage of 10 V is applied to the rubber heater, and the temperature is measured after 30 minutes.

### Measurement of Each Temperature:

The temperature at the high-temperature-side end and the temperature at the low-temperature-side end of each thermoelectric conversion layer are measured based on infrared thermography using "Neo Thermo TVS-700" manufactured by Nippon Avionics Co., Ltd. The temperature difference is also calculated. These results are also shown in Table 1.

### Analysis of Temperature Difference:

It is clear that samples 1 to 4 are preferable since the temperature difference increases with increasing thickness. In particular, as compared with sample 6 in which a heat insulation layer is not provided, it is clear that a large temperature difference can be obtained by simply providing a heat insulation layer that is 0.1 mm thick. Furthermore, when the thickness of the heat insulation layer ranges between 0.1 mm and 1.5 mm, the temperature difference substantially increases in proportion to the thickness. In this range, it is clear that increasing the thickness of the heat insulation layer is effective. On the other hand, in a comparison between sample 4 having a thickness of 1.5 mm and sample 4 having a thickness of 2.0 mm, an increase in temperature difference is slightly small. Accordingly, it is clear that the thickness of the heat insulation layer preferably ranges between 0.5 mm and 1.5 mm.

Furthermore, in sample 7 in which the heat insulation layer and the heat conduction layers are arranged next to each other, the temperature difference is smaller than in sample 1. It is clear that the configuration of the present invention is extremely advantageous over the configuration of the thermoelectric conversion element having the heat conduction layers disposed as in the related art shown in Fig. 12.

### Reference Signs List

1, 11, 21, 31, 41, 51 thermoelectric conversion element
12 base sheet
   12a front surface (first surface)
   12b back surface (second surface)
   12c through-hole
13 thermoelectric conversion layer
   13a to 13d thermoelectric conversion layer
14 electrode
   14a first electrode
   14b second electrode
   14c wire
   14d external contact
15 heat insulation layer
16 protection layer
16a thin section
16b thick section
17 adhesive layer
18 heat-generating component
19 release sheet
20 heat conduction layer

## Claims

1. A thermoelectric conversion element comprising:
a thermoelectric conversion layer having flexibility;
a first electrode provided at one end of the thermoelectric conversion layer;
a second electrode provided at the other end of the thermoelectric conversion layer; and
a heat insulation layer provided at a position overlapping the first electrode in a thickness direction of the thermoelectric conversion layer,
wherein in a state where the heat insulation layer is attached to a heat-generating component, the thermoelectric conversion layer bends and deforms so that the first electrode is disposed farther away from the heat-generating component than the second electrode owing to the heat insulation layer.

2. A thermoelectric conversion element comprising:
a base sheet having flexibility;
a thermoelectric conversion layer having flexibility and provided at the base sheet;
a first electrode provided at one end of the thermoelectric conversion layer;
a second electrode provided at the other end of the thermoelectric conversion layer; and
a heat insulation layer provided at a position overlapping the first electrode in a thickness direction of the base sheet,
wherein in a state where the heat insulation layer is attached to a heat-generating component, the base sheet and the thermoelectric conversion layer bend and deform so that the first electrode is disposed farther away from the heat-generating component than the second electrode owing to the heat insulation layer.

3. A thermoelectric conversion element comprising:
a release sheet;
a thermoelectric conversion layer having flexibility and provided at the release sheet;
a first electrode provided at one end of the thermoelectric conversion layer;
a second electrode provided at the other end of the thermoelectric conversion layer; and
a heat insulation layer provided at a position overlapping the first electrode in a thickness direction of the release sheet,
wherein in a state where the heat insulation layer is attached to a heat-generating component, the release sheet and the thermoelectric conversion layer bend and deform so that the first electrode is disposed farther away from the heat-generating component than the second electrode owing to the heat insulation layer.

4. The thermoelectric conversion element according to Claim 3,
wherein the release sheet is releasable in the bent and deformed state.

5. The thermoelectric conversion element according to any one of Claims 1 to 4,
wherein the heat insulation layer has a thickness of 0.1 to 2.0 mm.

6. The thermoelectric conversion element according to any one of Claims 1 to 5,
wherein a length from an end of the first electrode to an end of the second electrode provided at the thermoelectric conversion layer is 1 to 50 mm.

7. The thermoelectric conversion element according to any one of Claims 1 to 6, further comprising:
a protection layer that covers the thermoelectric conversion layer.

8. The thermoelectric conversion element according to Claim 7,
wherein the protection layer has a thin section located at a position overlapping the heat insulation layer and a thick section located at a position not overlapping the heat insulation layer.

9. The thermoelectric conversion element according to any one of Claims 1 to 8, further comprising:
an adhesive layer to be attached to the heat-generating component.

10. An attachment structure for attaching the thermoelectric conversion element according to any one of Claims 1 to 9 to a heat-generating component,
wherein the first electrode is disposed farther away from the heat-generating component than the second electrode at least by a distance equivalent to a thickness of the heat insulation layer.
